Europäisches Patentamt

European Patent Office

Office européen des brevets

(19)

(11)     **EP 1 360 760 B1**

(12)     **EUROPEAN PATENT SPECIFICATION**

(45) Date of publication and mention
of the grant of the patent:
**12.01.2005  Bulletin 2005/02**

(21) Application number: **01962897.3**

(22) Date of filing: **01.08.2001**

(51) Int Cl.⁷: $H03G\ 11/00$, $H03G\ 7/06$

(86) International application number:
**PCT/EP2001/008921**

(87) International publication number:
**WO 2002/011283 (07.02.2002 Gazette 2002/06)**

(54) **AMPLITUDE LIMITATION**

AMPLITUDENBEGRENZUNG

LIMITATION D'AMPLITUDE

(84) Designated Contracting States:
**AT BE CH CY DE DK ES FI FR GB GR IE IT LI LU
MC NL PT SE TR**

(30) Priority:  **01.08.2000  EP 00116594**

(43) Date of publication of application:
**12.11.2003  Bulletin 2003/46**

(73) Proprietor: **Telefonaktiebolaget LM Ericsson
(publ)
164 83 Stockholm (SE)**

(72) Inventors:
• **LIPKA, Dietmar
92348 Berg (DE)**
• **FRANK, Georg
90425 Nürnberg (DE)**
• **KEHLENBACH, Werner
90491 Nürnberg (DE)**
• **GRIMME, Andreas
90408 Nürnberg (DE)**

(74) Representative: **Sjöberg, Mats Hakan
Ericsson AB
Patent Unit Radio Access
SE-164 80 Stockholm (SE)**

(56) References cited:
**WO-A-99/59265          US-B1- 6 236 864**

## Description

FIELD OF THE INVENTION

The present invention relates to a communication system. The present invention relates especially to limiting the amplitude of a transmission signal, e.g., a telecommunication signal to be transmitted via a radio station.

DESCRIPTION OF THE PRIOR ART

In telecommunications systems, usually a large number of communication channels is transmitted together via the same transmission medium, e.g., a radio frequency band. Various access schemes for placing communication channels on the transmission medium are known. A well-known scheme is CDMA (Code Division Multiple Access) where a number of different communication channels is transmitted simultaneously in a radio frequency band in such a way that they overlap in both the time domain and the frequency domain.

In order to distinguish each communication channel signal from the other communication channel signals, each communication channel signal is encoded with one or more unique spreading codes, as is well-known in the art. By modulating each of the communication channel signals with a spreading code, the sampling rate (i.e., the "chip rate") may be substantially increased in accordance with a spreading factor. For example, each communication channel signal is modulated in accordance with a digital modulation scheme, e.g., a quadrature amplitude modulation (QAM) or a phase shift keying (PSK) technique. Consequently, an in-phase and quadrature component signal is produced for each communication channel signal. QAM and PSK are well known in the art. The in-phase and quadrature component signals associated with each of the communication channels are then encoded using a unique spreading code sequence. The resulting in-phase and quadrature component signal pairs are sampled (i.e., at the chip rate) and individually weighted. The in-phase and quadrature component signals are eventually combined to form a composite in-phase signal and a composite quadrature signal. The composite in-phase signal and the composite quadrature signal are then separately filtered by a low-pass, pulse shaping filter. Subsequent to filtering, the composite in-phase signal and the composite quadrature signal are modulated by a cosine-carrier and a sine-carrier respectively and combined into a single, multicode transmission signal, e.g., a CDMA signal. The single, multicode transmission signal is then up-converted by a carrier frequency and the signal power associated with the transmission signal is boosted by a high power amplifier prior to transmission. At the receiving unit, the baseband signal associated with each of the communication channel signals is extracted from the transmission signal by demodulating and decoding the transmission signal using the carrier frequency and the various spreading codes. Furthermore, it will be understood that in a typical cellular telecommunications system, the transmission source may, for example, be a high power base station, and the receiving entity may, for example, be a mobile station (i.e., a mobile telephone).

PROBLEM OF EXISTING TECHNOLOGY

In a base station usually more than one communication channel signal has to be transmitted via a common carrier signal or via neighbored carrier signals, wherein each of the carrier signals is modulated with its own unique carrier frequency. The one or more modulated carrier signals are then amplified independently by a corresponding number of high power amplifiers prior to transmission. Alternatively in case of more than one carrier signal, the two or more modulated carrier signals are combined into a single transmission signal, which is then amplified by a single, high power amplifier prior to transmission.

As one skilled in the art will readily appreciate, CDMA substantially increases system bandwidth, which in turn, increases the network's traffic handling capacity a whole. In addition, combining independent carrier signals into a single complex transmission signal, as described above, is advantageous in that a single high power amplifier is required rather than a separate high power amplifier for each independent carrier signal. This is advantageous because high power amplifiers are expensive, and employing one high power amplifier in place of many will result in substantial cost savings.

Despite the advantages associated with CDMA, combining multiple communication channel signals and/or independent carrier signals, in general, significantly increases the peak-to-average power ratio associated with the resulting transmission signal. More specifically, the peak-to-average power ratio for a transmission signal can be determined approximately in accordance with the following relationship:

$$PAR_{PTA} = PAR_F + 10^* \log (N)$$

wherein $PAR_{PTA}$ represents the peak-to-average power ratio in dB of the corresponding composite signal, $PAR_F$ represents the power ratio in dB of the low pass, pulse shaping filter and N represents the number of communication channels which make up the carrier (CDMA) signal.

The problem associated with large peak-to-average power ratio is that it diminishes the efficiency of the high power amplifier in the transmitter. Efficiency as one skilled in the art will readily understand, is measured in terms of the amount of output power (i.e., $P_{mean}$) divided by the amount of supply power. As peak power $P_{peak}$ increases relative to $P_{mean}$, the efficiency of the high power amplifier decreases.

One possible solution is to simply limit or clip the amplitude (i.e., $P_{peak}$) of the carrier signal. Unfortunately, this is likely to result in the generation of intermodulation products and/or spectral distortions. Intermodulation products and/or spectral distortions are, in turn, likely to cause interference between the various communication channel signals. Accordingly, this is not a preferred solution.

In WO 99/53625 the applicant therefore proposed an apparatus that estimates the amplitudes of each of a plurality of complex digital carrier signals based on their complex signal components. The computed amplitudes are then used to determine at least one scaling factor for scaling the complex components of each of the plurality of complex digital carrier signals prior to combining the complex amplitude limited carrier signals to form a transmission signal.

WO 00/33477, shows a peak power regulator in a CDMA transmitter for reducing PAPR (Peak Average Power Ratio) inputted to power amplifiers. The regulator comprises a delay line, a squared magnitude predictor estimating the magnitude of the envelope, that will be generated when the inputted baseband signals are modulated. The estimate is inputted to a multiplier that generates a ratio by dividing the estimate by a maximum acceptable envelope magnitude. The ratio is subsequently input to a mapping table that outputs a scaling factor. WO00/33477 forms the preamble of claim 1.

Limiting the amplitude of a carrier signal allows reducing the maximum amplitude of the complex transmission signal in an efficient way. By reducing the amplitude the amplifier is prevented from being driven into its non-linear range. Thus additional intermodulation products etc. are avoided. For iterative estimation of the amplitudes of the individual carrier signals the CORDIC algorithm has been proposed. The amplitude of a signal may be estimated with a sufficient accuracy employing at least two iterations according to the CORDIC algorithm.

As the amplitudes are limited before the signals are applied to pulse shaping filters the spectral width of the signal at the output of the pulse shaping filters still will stay within the limits that are given by the pulse shaping filters characteristics. Therefore this method is appreciated for its effectiveness and simplicity. However, increases of the peak amplitude by overshoots of the pulse shaping filters have been observed. In Wideband CDMA systems, where root raised cosine filters (RRC) are used as pulse shaping filters these overshoots can cause a typical maximum additional peak to average value up to 4.5 dB higher than the peak to average amplitude after clipping. However these overshoots do not occur very frequently in a random like Wideband CDMA signal. Considering peak events with a probability (i.e. complementary cumulative density) greater than $10^{-4}$ only then the overshoots will increase the peak to average value only by 2.5 dB.

OBJECT OF THE INVENTION

A simple solution would be to use an appropriate higher back-off. However, as this considerably lowers the dynamic range of the transmitter Digital-to-Analogue converters with a corresponding larger range are required. But also designing the amplifier for a higher linearity range causes supplemental costs. It is therefore an object of the invention to ensure that signal overshoots introduced by devices that are inserted subsequent to amplitude limitation means do not substantially drive the power amplifier into a non-linear range nor do raise the costs for dimensioning the power amplifier.

SUMMARY OF THE INVENTION

This object is achieved by providing the estimation means with an estimation filter for determining the actual signal overshoot over a predefined threshold value that is introduced by devices that are inserted subsequent to the means for limiting the amplitude of the transmission signal. By this all signal overshoots that are introduced in a later processing stage can be taken into account. Thus it becomes obsolete to dimension the power amplifier with a safety margin for the overshoots of the later stages.

The simplest embodiment is to implement the estimation filter as a copy of all signal affecting circuits in the subsequent signal path. However this solution may be suboptimal in view to implementation costs and signal delay. In a preferred embodiment of the invention the estimation filter shows less complexity than the circuits in the actual signal path. By this the estimation filter is less expensive than a copy of the actual circuits and it could be optimized to show less delay time than the subsequent signal path.

In another embodiment of the invention as an estimation filter only a replica of the pulse shaping filter is used. Depending on the (linearity of the) circuits in the subsequent path this could be a very effective restriction that is inexpensive but still with sufficient performance. Thus accurate clipping can be achieved with reasonable implementation costs, small output delay and with a constant computational load.

In another embodiment of the estimation filter the peaks of the signal overshoots are calculated by means of a recursive algorithm. That algorithm searches for signal peaks introduced by the amplitude affecting circuits, compensates the peaks and in recursive program calls thus eliminating peaks that are introduced by the compensation.

In a further embodiment the amplitude limitation device is carried out by means of a multiplier that multiplies the transmit signal with a scaling factor. In an alternative embodiment of the amplitude limiting device this device is implemented by means of signal superimposition. That means that an adder is used to add a sequence of compensation samples to the transmit signal or as an equivalent solution to subtract a correspondingly complementary sequence of samples.

BRIEF DESCRIPTION OF THE INVENTION

In the following the invention will be further described according to the figures and by means of examples

Fig.1: is a block diagram of a communication system in which the invention can be used
Fig. 2 shows the general construction of a transmitter for a radio communication system, and
Fig. 3 shows a detail of a transmitter with a clipping arrangement according to the invention.

DETAILED DESCRIPTION

In the following description, for purposes of explanation and not limitation, specific details are set forth, such as particular embodiments, circuits, signal formats, techniques, etc. in order to provide a thorough understanding of the present invention. However, it will be apparent to one skilled in the art that the present invention may be practiced in other embodiments that depart from these specific details. For example, while the present invention is described in the context of a base station transmitter, the present invention may be applied to any transmitter, e.g. in a mobile station. In other instances, detailed descriptions of well-known methods, devices, and circuits are omitted so as not to obscure the description of the present invention with unnecessary detail. Moreover, individual function blocks are shown in some of the figures. Those skilled in the art will appreciate that the functions may be implemented using individual hardware circuitry, using software functioning in conjunction with a suitable programmed digital microprocessor or general purpose computer, using Application Specific Integrated Circuit (ASIC), and/or using one or more Digital Signal Processors (DSPs).

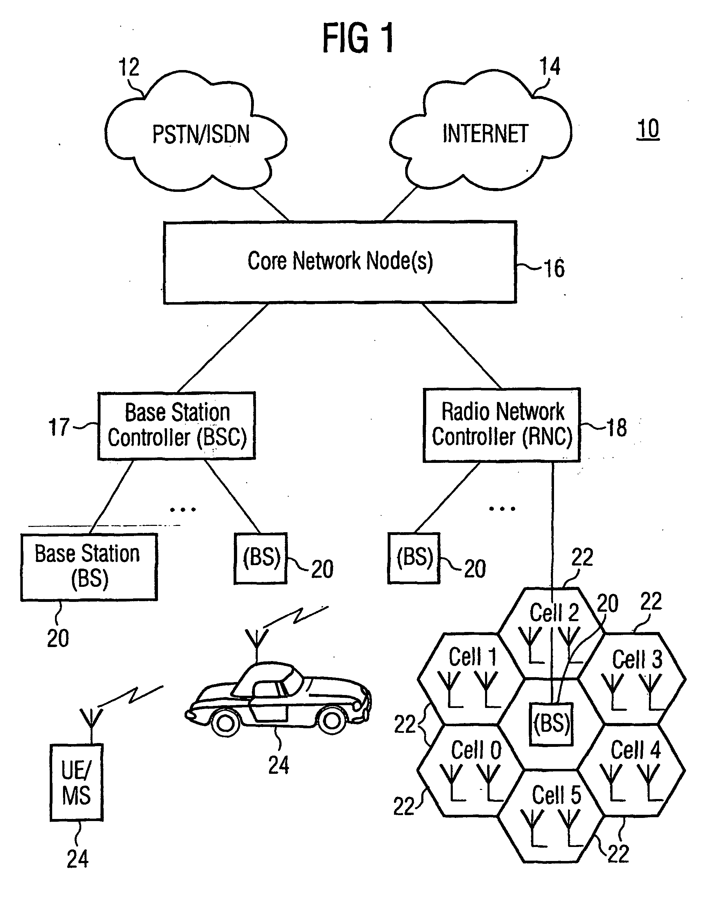

The present invention is described in the context of a CDMA cellular radio telecommunications system 10 as shown in Fig. 1. A representative, circuit-switched, external core network shown as cloud 12, may be for example the Public Switched Telephone Network (PSTN) and/or the Integrated Services Digital Network (ISDN). A representative, packet-switched, external core network shown as cloud 14, may be for example the Internet. Both core networks are coupled to one or more core network nodes 16. Examples of core network service nodes in a mobile switching center (MSC) node and a gateway MSC (GMSC) provide switching services and a serving general packet radio services (GPRS) support node (SGSN) and a gateway GPRS support node (GGSN) to provide packet services. The core network service node(s) is(are) connected to one or more base station controllers 17 and/or one or more radio network controllers (RNCs) 18. Each such controller establishes and releases a particular connection between one or more base stations (BSs) 20 and user equipment (UE)/mobile station (MS) 24 including the selection and allocation of spreading codes and diversity handovers. A base station 20 handles the CDMA radio interface to mobile station 24 and includes radio equipment such as transceivers, digital signal processors, and antennas required to serve each cell and cell sector in the network. As shown for one base station 20, each base station may include multiple cells 22, and each cell preferably includes two diversity antennas.

As an embodiment of the invention a transmitter for wideband code division multiplex access (W-CDMA) communication systems has been chosen. W-CDMA, as it is designed and standardized at the moment by 3GPP (third generation partnership project), provides direct sequence spreading to allow different users to share a common carrier frequency band by applying uniquely assigned code sequences, so-called spreading codes to their data. The prefix "Wideband" has been chosen as the common frequency band covers five Megahertz. It is a general property of direct sequence spreading that the data rate of the spreading codes is always higher than the data rate of the user data. To distinguish the bits of the user data from the bits of the spreading code a bit of the spreading code is called chip and the data rate of the spreading code therefore chip rate. The sum of all signals in a CDMA frequency band appears statistically as a random signal, comparable to a noise signal. As the spreading codes are usually chosen in a way that they are orthogonal a receiver with the knowledge of a particular used spreading code is capable to extract a signal transmitted by a specific user from that "noise signal".

To improve the performance of 3GPP W-CDMA systems the spreading codes are composed of two separate codes in a way that preserves the orthogonal properties of these codes. A first code is used to distinguish different users in a cell from each other. As by this first code a separate physical channel can be assigned to each user (in the same frequency band) this first code is called channel code $c_{ch}$. As the codes are constituted in an appropriate way it is very easy to adapt the data rate of each channel by assigning a channel code with an appropriate length. A second code, the scrambling code $c_{scramb}$ is used to distinguish neighbored or overlaid cells.

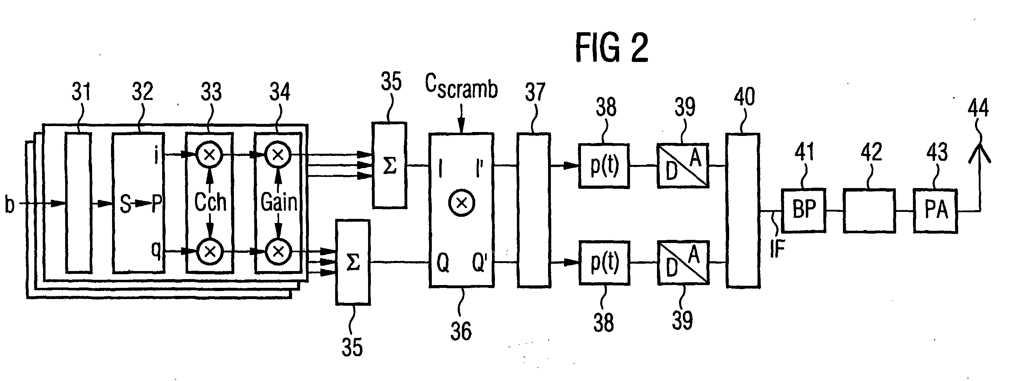

Fig. 2 shows a block diagram of a radio transmitter according to the invention designed for a base station of a W-CDMA system in which up to the generation of a first intermediate frequency (IF) signal all signals are processed exclusively as digital signals. The digitally generated intermediate frequency signal IF is then converted to an analogue signal and up-converted to a desired transmitter radio frequency signal.

Binary user data b, which is a multiplexed binary data stream of useful bits (e.g. digital encoded speech signals) and control information is encoded and interleaved in an encoder and interleaver 31. As in down-link the W-CDMA systems applies a QPSK-modulation scheme, every two succeeding bits of the binary data stream at the output of the interleaver 31 are mapped by a base band modulator 32 to a complex base band format, consisting of an in-phase component i and a quadrature component q. Each component is still a binary signal. To distinguish the data of different users a channel spreader 33 multiplies each base band signal component i, q with a binary channel code sequence $c_{ch}$ that has been assigned individually to each user. Thus the output signal of the channel spreader 33 is still a binary signal. To adjust the output power of each channel the channel coded in-phase and quadrature binary signals are multiplied by gain control means 34 with a gain factor GAIN giving samples with a bit width greater than one. In this embodiment the bit width of those samples has been chosen to fourteen bits.

For reasons of clarity up to here only the processing of a single channel has been described. In a base station of course a multitude N of channels is processed in parallel. To form a single wideband output signal the in-phase and the quadrature components i, q of all these channels 1 ... N are summed up separately by two adders 35 giving sum signals I and Q. In a commercial product the number of channels is e.g. sixty four or even twice this number. By means of a complex multiplier 36 these signals are multiplied with the complex scramble code $c_{scramb}$. Each scrambled component signal I', Q' is then processed separately again. As in 3GPP the chip rate of the scrambling code sequence $c_{scramb}$ and channel code sequence $c_{ch}$ as well have been fixed to 3,84 Megachips per second (Mcps) the sample rate of the two scrambled component signals I', Q' is increased by spreading and scrambling to this value. The baseband signal I,Q is then processed in a clipping unit 37 to generate a clipped baseband signal $\overline{I},\overline{Q}$.

By means of the digital filter arrangement 38 the component signals I', Q' are shaped and up-sampled to 30,72 Msps. Then the up-sampled digital component signals are converted by two digital-to-analogue converters (DAC) 39 to analogue component signals. A quadrature modulator 40 modulates in well-known manner the composite analogue in-phase signal by a cosine-carrier and the composite analogue quadrature signal with a sine-carrier, both having the same frequency. The quadrature modulator 40 then combines the modulated, composite in-phase signal with the modulated, composite quadrature signal thus generating an intermediate frequency signal IF. A conventional band pass filter 41 connected to the output of the quadrature modulator 40 suppresses undesired intermodulation signals. The band-passed filtered intermediate frequency signal is fed to an up-converter arrangement 42 by which the intermediate frequency signal is up-converted to the given carrier frequency. The up-converted carrier signal is then amplified by a power amplifier 43 and fed to an antenna 44.

Considering only the influence of the number N of multiplexed baseband signals the ratio of peak amplitude to average amplitude (PAR) is equivalent to 10 log(N) dB. Thus in case of sixty four multiplexed signals the Peak to Average Ratio PAR is about 18,1 dB and for one hundred twenty eight multiplexed signal the Peak to Average Ratio PAR is about 21,1 dB. It is evident that designing a power amplifier with an according backoff to cope with such high peak amplitudes is extremely expensive. However, due to the quasi random nature of the multiplexed W-CDMA baseband the frequency of signals with a high peak amplitude declines with their amplitude. As each channel is multiplied with its own orthogonal code sequence $c_{ch}$ and the number of individual channels is sufficiently high the sum signal of the individual channels r, Q' signals has properties of a white gaussian noise signal with a mean power $P_{mean}$. This mean power $P_{mean}$ is correlated to an average amplitude of that signal. A design criteria of a power amplifier PA that has a high impact on circuit costs besides the mean power is the linearity range in which an amplitude is not deteriorated. One reason why driving an amplifier into a non-linear range has to be avoided is that due to intermodulation effects out-off band emissions are generated which cause distortions in other frequency bands. As a design criteria the probability that peak amplitudes above the linear range $a_{max}$ occur have been chosen to be less than $10^{-4}$. Under this restriction the effective peak-to-average ratio, which has to be regarded in amplifier design, has the realistic value of 9,65 dB. However this value is also too high for economic high power amplifier design. A way out of this dilemma is to limit the amplitudes to a given maximum amplitude $a_{max}$. As mere clipping of the amplitudes would change the spectrum of the transmit signal too much adaptive clipping is well used in prior art. In a signal interval that is larger than the peak itself, all amplitudes are scaled down, thus that the peak amplitude does not exceed the chosen maximum amplitude $a_{max}$.

As by this a certain number of chips during a symbol or bit duration is destroyed as a consequence this leads to a corresponding increase of the bit error rate in a receiver. By setting the clipping amplitude $a_{max}$ the peak-to-average ratio of the clipped transmission signal can be set to a certain value. With a reduced peak-to-average ration also the linearity range of the power amplifier can be reduced accordingly. But as the bit error rate of the received signal increases with decreasing clipping amplitude the value of the clipping amplitude is a result of a tradeoff between an intentionally admitted deterioration of the received signal and the costs that can be saved by this measure. Simulations for a 3GPP W-CDMA system have shown that setting the clipping amplitude to a value that results in a reduction of 2,8 dB peak-to-average ratio does increase the bit error rate in case of $E_b/N_0 = 2dB$ from $0.9 \cdot 10^{-3}$ to $10^{-3}$ (Please look in Fig. 9 at the curve Conv which stands for conventional clipping or prior art clipping respectively). That increase seems tolerable. Of course no general rule can be given as the result depends from various factors like the system parameters (modulation scheme, encoding, error protection, ...) and propagation conditions like channel properties, number of propagation paths, fading frequencies, and noise as well. A reduction of 3dB in the dimension of the peak power of an amplifier means that the main costs for the semiconductors and for heat sink are reduced to a half.

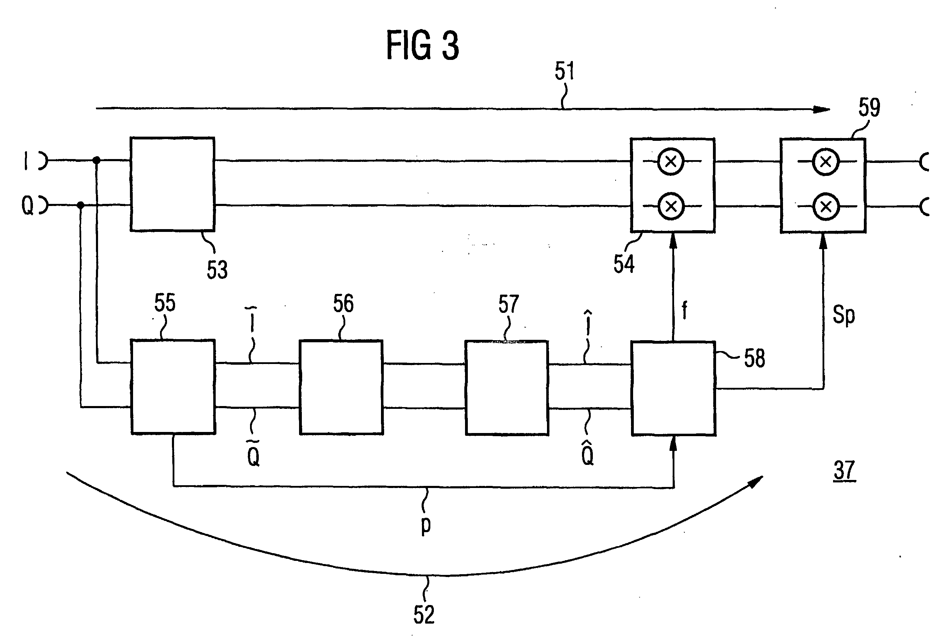

To illuminate the adaptive clipping scheme of the present invention reference is made now to figure 3 which shows the clipping unit 37 in more detail. This clipping scheme has one main branch, the transmit path 51 and the so-called test path 52. The transmit path 51 should be understood to extend also behind the clipping unit 37 until the antenna 44. In the transmit path 51 a delay means 53 is inserted for compensating the processing delay introduced by the test path 52. The delayed baseband signal I, Q is clipped by clipping means 54. The clipping function of the clipping means 54 is controlled by a settable threshold t and a scaling factor f that has been evaluated in test path 52. A signal the amplitude of which exceeds the given threshold t is scaled down by the scaling factor f. As the delayed baseband signal is multiplied with the scaling factor f only the amplitude of the baseband signals is modified. This kind of clipping is one of the most simplest forms of clipping. However, the general idea of the invention to use an estimation filter in a test path is applicable to any form of clipping, e.g. to clipping methods that do not only change the amplitude of the signal to be clipped but also do modify its phase.

To calculate the scaling factor f the undipped baseband signal I, Q first may be pre-clipped to a fixed predetermined clipping level by a pre-clipping means 55 by a pre-clipping factor p. The pre-clipped signal $\tilde{I}$, $\tilde{Q}$ then passes a test filter 46 that has the same, or at least comparable pulse shaping characteristics as the pulse shaping filter 38 that succeeds the clipping means 31. In the preferred embodiment the impulse response of this test filter 56 is a down-sampled version of the pulse shaping filter 38 in the transmit path. If the test filter 56 is designed too simple in some worst case overshoot amplitudes, which may be slightly larger than the sampled values may be missed by the test filter 56. For ensuring higher precision in overshoot estimation a subsequent interpolation block 57 may be included as an option, too. The output of the interpolation means 57 is a test signal $\hat{I}, Q$ that in ideal circumstances is an adequate estimate of the signal in the transmit path after the pulse shaping filter 38 that would appear if no clipping is applied. Thus test filter 56 and interpolation means 57 constitute an estimation filter.

By comparing the test signal $\hat{I}, Q$ and a given limit $a_{max}$ for the amplitude a clipping control means 58 decides if clipping has to be performed. In case of clipping the factor f is calculated to determine to which extend the delayed baseband signal I, Q of the transmit path 51 has to be scaled down. The factor f of course has to include the pre-clipping factor p of the pre-clipping unit 55 if the pre-clipping unit 55 is inserted in the test path 52. In case a pre-clipping unit is inserted in the transmit path 51 before the test path 52 is split apart the pre-clipping factor must not be considered by clipping control means 58. As already discussed in prior art clipping may also be achieved by adjusting the threshold t at which clipping is triggered using a fixed clipping factor f. A person skilled in the art will appreciate that any combination of adjusting clipping level, using fixed or varying scaling factors, or any other technique to adjust the baseband signal is within the teaching of the invention.

The pre-clipping means 55 is optional and may be used to reduce the complexity of the test filter 56 and the interpolation means 57. Another advantage is that by pre-clipping the possible numeric range of the samples is reduced thus that the further calculations can be carried out with a reduced word length. Amplitudes of the unclipped baseband signal I, Q that exceed a given pre-clipping threshold $t_p$, that may be larger than the given amplitude limit, are reduced, e.g. by a constant factor p. The pre-clipping threshold $t_p$ and the factor p may be chosen thus that a reduced number of baseband signals with too high amplitude still remain which have to be further processed in the test path. The pre-clipping means 55 may also be designed thus that all amplitudes above the given limit for the amplitudes are reduced thus that they do not exceed the given limit. In this case the test filter 56 and the interpolation means 57 must only take into consideration the overshoots caused by the fully limited baseband signal $\bar{I}, \bar{Q}$.

Although the estimation filter 56, 57 may be used to estimate all effects of linear distortions in the transmit path in the preferred embodiment for a Wideband-CDMA transmitter for a 3GPP system it turned out to be sufficient to consider only the impact of the pulse shaping filter 38 as the main contributor to overshoots. In the current application the pulse shaping filter 38 is a combination of a root raised cosine filter and several up-sampling stages. The clipped baseband signal I, Q is represented by a pair of fourteen bit samples at a sampling rate of 3.84 Msps. The root raised cosine filter is implemented as a finite impulse response filter (FIR) with seventy seven taps. The signal is up-sampled four times, each time by a factor of two. After each up-sampling step the up-sampled signal is interpolated by an interpolation filter. The design is made thus, that the three interpolation filter are identical at each stage. The interpolation filter are also implemented as FIR filter, each having twenty two taps. Thus for the pulse shaping filter 38 in each signal branch 143 taps are used in total. Depending on the degree of accuracy it is apparent that it is rather complex to imitate this filter. However, to fulfill the technical regulations of the specifications for 3GPP W-CDMA the pulse shaping filter 38 has to be very accurate and follows with high precision the exact mathematical filter characteristic of a raised root cosine filter. In fact the signal difference between the root raised cosine function and the implemented pulse shaping filter 38 is far lower than the tolerance that has been decided to be tolerable for the approximation by the estimation filter 56, 57. Therefore in the preferred embodiment the estimation filter 56, 57 estimates rather the root raised cosine filter than to try to estimate the signal response of the original pulse shaping filter 38.

Since the estimation filter is used only to determine the clipping level, but not to generate a radio signal with full accuracy the amplitude information is of greater importance than other filter criteria like phase information. Therefor a replica of the pulse shaping filter with sufficient amplitude accuracy can be designed with a FIR filter with about twenty to thirty taps. Although this means a reduced complexity in comparison to the original pulse shaping filter 38 with 143 taps a even smarter solution has been found.

A preferred embodiment of the estimation filter could be imagined as a complex representation, e.g. all signal samples must be seen with their in-phase and their quadrature component Such a filter is based, like the pulse shaping filter 38 on a finite impulse response filter. The estimation filter comprises a number $n_t$ of taps and a number $n_s$ of adders. Hereby the number of adders $n_s$ is lower or equal than the number $n_t$ of taps. For reasons of conciseness the filter is shown with three taps and three adders. The optimum number of taps and adders will be discussed later on. Each adder calculates the sum of individually weighted outputs of each tap. The output of the taps are multiplied in multipliers with weighting factors $w_{11}$ ... $w_{33}$. Thus by properly assigning the weighting factors $w_{11}$ ... $w_{33}$ each adder is calculating one of the oversampled estimates of the pulse shaping filter 38. Weighted clipping, as this method is named takes advantage from the fact that when clipping starts and ends at fixed time instants, e.g. the chip interval, the accurate time instant of the peak amplitude within that time interval must not be known. Therefore the preferred embodiment does not consider the time instants inserted by up-sampling and leads same taps ofthe finite impulse response filter to different adders. Although the output of the adders correspond to different time instants, but within the clipping interval they can be summed up and compared at the same time. The output of the adders are input to amplitude determination means that determine the value of the amplitude from their complex representation. A method well known from prior art, like the CORDIC algorithm is used for this purpose. A maximum determination unit 64 outputs the maximum found amplitude precast $\hat{a}$ among the output values of amplitude determination means. This maximum amplitude precast $\hat{a}$ is input to a limiter. The limiter outputs the scaling factor f, which is exact one if no limitation is needed. Otherwise the limitation factor is the ratio between clipping amplitude and the maximum precast amplitude $\hat{a}$

As it mentioned in the foregoing, the complexity of the estimation filter 56, 57 is tied to the approximation error. The more accurate the approximation is the less backoff margin is needed. Simulation results have shown that using more than seven taps for the test filter 56 and using more than five adders in the interpolation filter 57 may improve accuracy but does not improve the performance of the clipping method. However as the admissible probability that the Peak to Average Ratio PAR exceeds $10^{-4}$ is chosen somehow in rough guess also the effect of this limit has been verified by simulations evaluating the Bit Error Rate and Modulation Error. The results show that the performance loss by a clipping method according to the invention is equal to only 0,25 SNIR (signal-to-noise interference).

The weighting factors $w_{mn}$ in the impulse response of the root raised cosine filter 38 can be calculated from the formula

$$w_{mn} = \Psi\left(\hat{t} + T_c\left(\frac{2m - n_t - 1}{2}\right)\left(\frac{n - (n_s + 1)/2}{\max(2[(n_s)/2],1)}\right)\right)$$

where $T_o$ is the chip interval and $\hat{t} = \text{argmax } \Psi(t)$.

As it is known from prior art in systems using a power control loop between transmitter and receiver must ensure that the clipping does not change the mean power. Otherwise the power control loop will steadily increase the transmit power to counterfeit assumed transmission losses that are in reality the result of the clipping. Therefore the control unit 58 also generates a power adaptation control signal $S_p$ that is input to a power adaptation unit 59. In the power adaptation unit 59 the input samples are re-scaled by means of the power adaptation signals $S_p$. That means that in a time interval preceding and/or succeeding the clipped peak amplitude the samples are enlarged to hold within that time interval the mean power constant As an easy to handle time interval the time interval $T_o$ of a chip sequence is preferably chosen. In this embodiment scaling factor f and power adaptation factor $S_p$ each control a multiply operation of the in-phase and quadrature samples of the complex transmission signal I, Q.

According to the amplitude limitation of the invention, after adaptive clipping all samples are within a circle that corresponds to the clipping amplitude $a_{max}$. As it can be understood also all phase information has been let untouched.

In another embodiment of the invention, the estimation filter is implemented by an algorithm that searches for signal peaks exceeding a certain threshold. In the main branch of the clipping device 37, according to such an embodiment, there is still delay means and clipping means. In contrast to clipping means of the first embodiment clipping is achieve by superimposition of a correction sequence $\Delta c$. This algorithm may be carried out for example by a digital signal processor (DSP). In a combined step the peak search algorithm calculates a compensation signal or a sequence of digital compensation samples respectively that are subtracted from the transmit signal to achieve directly the desired amplitude limited signal and to maintain at the same time the mean transmit power. In mathematical terms this can be expressed as that the absolute value of the amplitude limited signal $\tilde{s}(t)$ as the target function has to be lower or equal a given threshold $Th_p$. The desired amplitude limited *signal* $\tilde{s}(t)$ is the sequence of symbols c[k] that have been convoluted with the function $\Psi$ that represents the undesired amplitude affecting effects, e.g. overshoots etc. of circuits subsequent to the amplitude limiter 37. As in the foregoing example the pulse shaping filter 38 is considered as the main contributor this function can be restricted to the contribution of the pulse shaping filter 38. Thus the following equation is obtained:

$$\left| \tilde{s}(t) \right| = \left| \sum_{k=0}^{k_m} c[k] \Psi(t - kT_c) \right| \le Th_p \qquad (1)$$

As boundary conditions the mean square error between each symbol c[k] and the corresponding symbol $\tilde{c}(k)$ that is obtained by amplitude limitation has to be a minimum. Unfortunately the solution of this problem is only possible as soon as the complete chip sequence is known. Since real communication systems require a limited latency time or output delay the optimal solution cannot be used in praxis. As a way out the proposed algorithm searches for peaks, that are defined that their amplitude of a signal s(t) exceeds a threshold $S_p$ and there is a local minimum at time $t_p$. This peaks are modified by a sequence of compensation signals to achieve the desired amplitude limited signal. Since this modification could produce new peaks, the algorithm looks for new introduced peaks and therefore has to be carried out recursively until all peaks have been removed.

In the following the algorithm is disclosed in a C-style pseudo code that offers more detail of the algorithm:
Variables:

$t_{\psi,1}, \Delta t\Psi$:     begin and length of the interval where $\Psi$ does not deliver any substantial contribution
$\Delta k_1$ :     delay between algorithm input and output
c[k]:     array with original chip sequence
$\tilde{c}[k]$     array with modified chip sequence
$t_p$ :     position of last removed peak
$k_{max}$:     index of currently available element c[k]

$$k_{max} = 0; \ t_p = 0; \ c[k] = 0$$

**repeat until all peaks removed {**

```
wait until c[k_max] is available;
```

$$\tilde{c}[k_{max}] = c[k_{max}]$$

```
while ( incremental search from t_p to k_max T_o + t_ψ,1 yields peak s̃(t_p,2) ){

    do {

        t_p = t_p,2;

        remove peak at t_p;

        while ( decremental search from t_p to t_p - Δt_ψ yields peak s̃(t_p,2) );

    }

    output C_MPC · c̃[k_max - Δk_1]

    k_max = k_max + 1;

}
```

The main loop is executed for every chip c[k], which becomes available. Then all peaks for $t < k_{max}T_o + t_{\psi,1}$ are removed. This part of s(t) is independent from chips with $k > k_{max}$, so that it will not be changed anymore when new chips become available. At the end, the chip $\tilde{c}[k_{max} - \Delta k_1]$, scaled with the appropriate mean power correction factor $C_{MPC}$ is output. In contrast to prior art clipping or the weighted clipping described before, there is no simple relationship between the mean power correction factor $S_p$ used there and the mean power correction factor $C_{MPC}$ used here. $C_{MPC}$ for instance may be calculated by measuring the mean power over one time slot and adjusting the mean power accordingly that it is the same after clipping. The output delay $\Delta k_1$ is chosen sufficiently large, so that no further modifications of $\tilde{c}[k_{max} - \Delta k_1]$ must be expected. $\Delta k_1 > 2 \Delta t_\psi/T_o$ proved to be sufficient.

The overshoot error Δs(t) for a peak at the time $t_p$ can be calculated by

$$\Delta s(t) = \left(1 - \frac{Th_p}{|s(t_p)|}\right) s(t_p) \qquad (2)$$

This overshoot error Δs(t) has to be filtered according to

$$\Delta c[k] = \sum \Delta s(t_{p,\mu}) \Psi(t_{p,\mu} - (k - \mu)T_c) \qquad (3)$$

with the root raised cosine impulse response or with a limited interval of it. Thus a correction sequence for a detected peak amplitude at a time instance k is generated. This correction sequence enables the peak reduction with a minimal difference of original sequence and corrected/clipped sequence under the condition of a maximal allowed amplitude $a_{max}$. In contrast to prior art clipping and the weighted sum clipping not only a symbol at a time instant k is modified, but also symbols before and behind. Additional while Δs(t) is a complex value, both amplitude and phase are affected. However this is the reason for the superiority of this clipping method.

The recursive peak removal algorithm modifies a chip sequence. As can be understood, not only the amplitude, but also the chip phase is altered to achieve peak power reduction. The advantage of this method is that it is mathematically exact and thus always yields the best possible solution.

The results of prior art clipping (curve Conv), weighted sum clipping (curve WSC with an estimation filter with 5 taps and five adders) and recursive peak removal (curve RPR) are compared with at $E_b/N_0 = 2$ dB in a simulation for a 3GPP system. For example at a tolerated bit error rate of $10^{-3}$ the benefit with weighted sum clipping is 1,2 dB in comparison to prior art clipping. With recursive peak removal the gain is even more than 2 dB in comparison to prior art clipping. However if a higher bit error rate is tolerate the benefits even slightly increase.

Accordingly, while the present invention has been described with respect to a particular embodiment, those skilled in the art will recognize that the present invention is not limited to the specific embodiments described and illustrated herein. Different formats, embodiments, and adaptations besides those shown and described as well as many modifications, variations, and equivalent arrangements may also be used to implement the invention. E.g. usually the pulse shaping filter 38 is the only device in the transmit path that causes signal overshoots. So it is sufficient to design the test filter 56 according to the properties of the pulse shaping filter 38 in the transmit path. But as it will be readily appreciated any other or further amplitude or phase affecting device in the transmit path of a transmitter may be estimated by the test filter 56 and the interpolation means 57 and thus could be compensated by clipping means 54. The benefits of the invention are not restricted to single carrier amplifiers. Like in prior art discussed above the invention is of course applicable to multi carrier amplifiers. Therefore, while the present invention has been described in relation to its preferred embodiments, it is to be understood that this disclosure is only illustrative. Accordingly, it is intended that the invention be limited only by the scope of the claims appended hereto.

**Claims**

1.  Telecommunication device with means for limiting (37) an amplitude of a transmission signal derived from a sequence of input samples, comprising:

    -   amplitude adjusting means (58) to adjust the amplitude of said transmission signal
    -   estimation means (55, 56, 57) for estimating the amplitudes of said transmission signal
    -   control means (54, 58, 59) for calculating a maximum amplitude based on the estimated amplitude and using the result of the calculation for controlling the amplitude adjusting means

    **characterized in that**
    the estimation means (55, 56, 57) comprises an estimation filter (56) to determine the signal overshoot over a predefined threshold value that would be introduced by devices (38) that are inserted subsequent to the means for limiting the amplitude (37) of the transmission signal, if there were no limitation.

2.  Telecommunication device according to claim 1 whereby the estimation filter (56) is carried out as a copy of signal affecting circuits (38) in the transmission signal path.

3.  Telecommunication device according to claim 1 or 2 whereby the estimation filter (56) is a finite impulse response filter.

4.  Telecommunication device according to claim 3 with at least two adders, each adder having at least two inputs, whereby at least one of the taps of the FIR filter is input to more than one adder.

5.  Telecommunication device according to claim 1 or 2 whereby the estimation filter (56) is based on a recursive algorithm.

6.  Telecommunication device according to claim 1, 2, 3, 4 or 5 whereby the control signal controls a multiplier (54).

7.  Telecommunication device according to claim 1, 2, 3, 4 or 5 whereby the control signal is superimposed to the transmit signal.

8.  Telecommunication device according to one of claims 1, 2, 3 whereby the telecommunication device is a transmitter for wireless communication.

9.  Telecommunication device according to claim 5 whereby the telecommunication device is a base station for code division multiplex access system.

10. Method for limiting the peak-to-average power ratio of a transmit signal comprising the steps of:

    -   estimating the amplitudes of the transmit signal,

- calculating a maximum amplitude based on the estimated amplitude
- using the result of the calculation for adjusting the amplitude of the transmission signal

**characterized in that**
in the step of estimating the amplitudes of the transmit signal, the signal overshoot over a predefined threshold value that would be introduced by devices (38) that are inserted subsequent to means for limiting the amplitude (37) of the transmission signal, if there were no limitation, is determined and considered in the adjusting step.

11. Method according to claim 11 wherein a search for a peak amplitude that exceeds a given threshold is made, in case a peak amplitude is found that peak amplitude is removed by a compensation sequence and that the search for peaks exceeding the given threshold is repeated as often as a considerable peak remains.

12. Method according to claim 11 wherein the mean power of the uncorrected sample sequence and the corrected sequence is hold equal.

13. Computer program product with an executable computer program for carrying out one of the methods of claim 10 - 11.

**Patentansprüche**

1. Telekommunikationsvorrichtung mit einer Einrichtung zum Begrenzen (37) einer aus einer Folge von Eingangs-Abtastwerten abgeleiteten Amplitude eines Übertragungssignals mit:

- einer Amplituden-Einstelleinrichtung (58) zum Einstellen der Amplitude des Übertragungssignals;

- einer Schätzeinrichtung (55, 56, 57) zum Schätzen der Amplituden des Übertragungssignals;

- einer Steuereinrichtung (54, 58, 59) zum Berechnen einer maximalen Amplitude auf der Grundlage der geschätzten Amplitude und zum Verwenden des Ergebnisses der Berechnung zum Steuern der Amplituden-Einstelleinrichtung;

  **dadurch gekennzeichnet, daß**
  die Schätzeinrichtung (55, 56, 57) ein Schätzfilter (56) umfaßt, um das Signal-Überschwingen über einen vorbestimmten Schwellwert zu bestimmen, wenn es keine Begrenzung gäbe, wobei der Schwellwert durch Vorrichtungen (38) eingeführt würde, die nach der Einrichtung zum Begrenzen der Amplitude (37) des Übertragungssignals eingefügt werden.

2. Telekommunikationsvorrichtung nach Anspruch 1, wobei das Schätzfilter (56) als eine Kopie von signalbeeinflussenden Schaltungen (38) im Übertragungssignalweg ausgeführt ist.

3. Telekommunikationsvorrichtung nach Anspruch 1 oder 2, wobei das Schätzfilter (56) ein Filter mit begrenzter Impulsantwort (FIR) ist.

4. Telekommunikationsvorrichtung nach Anspruch 3 mit mindestens zwei Addierern, wobei jeder Addierer mindestens zwei Eingänge hat, wobei mindestens einer der Abgriffe des FIR-Filters in mehr als einen der Addierer eingegeben wird.

5. Telekommunikationsvorrichtung nach Anspruch 1 oder 2, wobei das Schätzfilter (56) auf einem rekursiven Algorithmus beruht.

6. Telekommunikationsvorrichtung nach Anspruch 1, 2, 3, 4 oder 5, wobei das Steuersignal einen Multiplizierer (54) steuert.

7. Telekommunikationsvorrichtung nach Anspruch 1, 2, 3, 4 oder 5, wobei das Steuersignal dem Übertragungssignal überlagert wird.

8. Telekommunikationsvorrichtung nach einem der Ansprüche 1, 2, oder 3, wobei die Telekommunikationsvorrichtung ein Sender für drahtlose Kommunikation ist.

**9.** Telekommunikationsvorrichtung nach Anspruch 5, wobei die Telekommunikationsvorrichtung eine Basisstation für ein Codemultiplex-Mehrfachzugriffssystem ist.

**10.** Verfahren zum Begrenzen des Verhältnisses zwischen Spitzenleistung und mittlerer Leistung eines Übertragungssignals mit folgenden Schritten:

- Schätzen der Amplituden des Übertragungssignals;
- Berechnen einer maximalen Amplitude auf der Grundlage der geschätzten Amplitude;
- Verwenden des Ergebnisses der Berechnung zum Einstellen der Amplitude des Übertragungssignals;

**dadurch gekennzeichnet, daß**
im Schritt des Schätzens der Amplituden des Übertragungssignals das Signal-Überschwingen über einen vorbestimmten Schwellwert, der durch Vorrichtungen (38) eingeführt würde, die nach der Einrichtung zum Begrenzen der Amplitude (37) des Übertragungssignals eingefügt sind, wenn es keine Begrenzung gäbe, bestimmt und im Einstellschritt berücksichtigt wird.

**11.** Verfahren nach Anspruch 10, wobei eine Suche nach einer Spitzenamplitude, die einen gegebenen Schwellwert überschreitet, durchgeführt wird, und wenn eine Spitzenamplitude gefunden wird, diese Spitzenamplitude durch eine Kompensationsfolge entfernt wird und diese Suche nach Spitzenwerten, die den gegebenen Schwellwert überschreiten, so oft wiederholt wird, wie ein erheblicher Spitzenwert übrigbleibt.

**12.** Verfahren nach Anspruch 11, wobei die mittlere Leistung der nichtkorrigierten Folge von Abtastwerten und der korrigierten Folge gleichgehalten wird.

**13.** Computerprogramm-Erzeugnis mit einem ausführbaren Computerprogramm zum Durchführen eines der Verfahren nach Anspruch 10 und 11.

**Revendications**

**1.** Dispositif de télécommunication avec un moyen pour limiter (37) une amplitude d'un signal de transmission qui est dérivé à partir d'une séquence d'échantillons d'entrée, comprenant:

- un moyen de réglage d'amplitude (58) pour régler l'amplitude dudit signal de transmission;
- un moyen d'estimation (55, 56, 57) pour estimer les amplitudes dudit signal de transmission;
- un moyen de commande (54, 58, 59) pour calculer une amplitude maximum sur la base de l'amplitude estimée et pour utiliser le résultat du calcul pour commander le moyen de réglage d'amplitude,

**caractérisé en ce que**:

le moyen d'estimation (55, 56, 57) comprend un filtre d'estimation (56) pour déterminer le sur-dépassement d'un signal par rapport à une valeur de seuil prédéfinie qui devrait être introduit par des dispositifs (38) qui sont insérés à la suite du moyen pour limiter l'amplitude (37) du signal de transmission, s'il n'y avait pas de limitation.

**2.** Dispositif de télécommunication selon la revendication 1, dans lequel le filtre d'estimation (56) est mis en oeuvre en tant que copie de circuits affectant le signal (38) dans la voie de signal de transmission.

**3.** Dispositif de télécommunication selon la revendication 1 ou 2, dans lequel le filtre d'estimation (56) est un filtre à réponse impulsionnelle finie (FIR).

**4.** Dispositif de télécommunication selon la revendication 3, avec au moins deux additionneurs, chaque additionneur comportant au moins deux entrées, dans lequel au moins l'une des connexions intermédiaires du filtre FIR est entrée sur plus qu'un additionneur.

**5.** Dispositif de télécommunication selon la revendication 1 ou 2, dans lequel le filtre d'estimation (56) est basé sur un algorithme récursif.

6. Dispositif de télécommunication selon la revendication 1, 2, 3, 4 ou 5, dans lequel le signal de commande commande un multiplicateur (54).

7. Dispositif de télécommunication selon la revendication 1, 2, 3, 4 ou 5, dans lequel le signal de commande est superposé sur le signal de transmission.

8. Dispositif de télécommunication selon l'une quelconque des revendications 1, 2, 3, dans lequel le dispositif de télécommunication est un émetteur pour une communication sans fil.

9. Dispositif de télécommunication selon la revendication 5, dans lequel le dispositif de télécommunication est une station de base pour un système à accès par multiplexage par division de code.

10. Procédé pour limiter le rapport de puissance crête sur moyenne d'un signal de transmission, comprenant les étapes de:

   - estimation des amplitudes du signal de transmission;
   - calcul d'une amplitude maximum sur la base de l'amplitude estimée;
   - utilisation du résultat du calcul pour régler l'amplitude du signal de transmission,

   **caractérisé en ce que**:

   au niveau de l'étape d'estimation des amplitudes du signal de transmission, le sur-dépassement d'un signal par rapport à une valeur de seuil prédéfinie qui devrait être introduit par des dispositifs (38) qui sont insérés à la suite du moyen pour limiter l'amplitude (37) du signal de transmission, s'il n'y avait pas de limitation, est déterminé et est considéré au niveau de l'étape de réglage.

11. Procédé selon la revendication 10, dans lequel une recherche d'une amplitude de crête qui excède un seuil donné est réalisée, dans le cas où une amplitude de crête est trouvée, cette amplitude de crête est enlevée au moyen d'une séquence de compensation et la recherche de crêtes excédant le seuil donné est répétée aussi souvent qu'une crête considérable persiste.

12. Procédé selon la revendication 11, dans lequel les puissances moyennes de la séquence d'échantillons non corrigée et de la séquence corrigée sont maintenue égales.

13. Produit de programme d'ordinateur comportant un programme d'ordinateur exécutable pour mettre en oeuvre l'un des procédés des revendications 10 et 11.

# FIG 1

# FIG 2

EP 1 360 760 B1

FIG 3